(19)

Europäisches Patentamt

European Patent Office

Office européen des brevets

(11) **EP 4 480 013 B1**

(12) **EUROPEAN PATENT SPECIFICATION**

(45) Date of publication and mention of the grant of the patent:
**11.02.2026 Bulletin 2026/07**

(21) Application number: **23704352.6**

(22) Date of filing: **15.02.2023**

(51) International Patent Classification (IPC):
*H10H 20/811* (2025.01)  *H10H 20/01* (2025.01)
*H01S 5/183* (2006.01)  *H01S 5/34* (2006.01)
*H01S 5/32* (2006.01)  *H10H 20/812* (2025.01)
*H10H 20/816* (2025.01)  *H10H 20/825* (2025.01)
*H01S 5/343* (2006.01)  *H01S 5/02* (2006.01)
*H01S 5/20* (2006.01)  *H01S 5/30* (2006.01)

(52) Cooperative Patent Classification (CPC):
**H10H 20/812; H01S 5/183; H01S 5/2009;**
**H01S 5/3216; H01S 5/3425; H10H 20/01335;**
**H10H 20/811; H10H 20/816; H10H 20/825;**
H01S 5/021; H01S 5/3054; H01S 5/341;
H01S 5/34333

(86) International application number:
**PCT/EP2023/053710**

(87) International publication number:
**WO 2023/156428 (24.08.2023 Gazette 2023/34)**

(54) **A DEVICE FOR EMITTING LIGHT AND A METHOD FOR PRODUCING A LIGHT-EMITTING DEVICE**

LICHTEMITTIERENDE VORRICHTUNG UND VERFAHREN ZUR HERSTELLUNG EINER LICHTEMITTIERENDEN VORRICHTUNG

DISPOSITIF D'ÉMISSION DE LUMIÈRE ET PROCÉDÉ DE FABRICATION D'UN DISPOSITIF ÉLECTROLUMINESCENT

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **18.02.2022 EP 22157544**

(43) Date of publication of application:
**25.12.2024 Bulletin 2024/52**

(73) Proprietor: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

(56) References cited:
**EP-A1- 1 959 530**  **EP-A1- 1 959 530**
**EP-A1- 2 838 125**  **EP-A1- 2 838 125**
**EP-A1- 2 955 763**  **EP-A1- 2 955 763**
**WO-A1-2013/049817**  **WO-A1-2013/049817**
**US-A1- 2011 233 575**  **US-A1- 2011 233 575**
**US-A1- 2012 292 592**  **US-A1- 2012 292 592**
**US-A1- 2014 183 446**  **US-A1- 2014 183 446**
**US-A1- 2015 318 448**  **US-A1- 2015 318 448**
**US-A1- 2021 057 601**  **US-A1- 2021 057 601**

• **WEISERT C: "Making C++ practical for business applications: 3 essential classes", SIGPLAN NOTICES, DEC. 1995, ACM, USA, vol. 30, no. 12, ISSN 0362-1340, pages 4 - 8, XP002082817**

**(Cont. next page)**

- **CAMPIONE M, & WALRATH K.: "The Java Tutorial - The String and StringBuffer Classes" [Online] Available from the Internet on 15 October 1998 at the URLs: <http://www.javasoft. com/docs/books/tutorial/essential/strings.html> and <http://www.javasoft.com/docs/books/ tutorial/essential/whytwo.html> XP002082819**
- **MARY CAMPIONE & KATHY WALRATH: "The Java Tutorial (First Edition)", February 1997, ADDISON-WESLEY, USA**

- **JOSUTTIS N: "Programming using the C++ standard library and STL", OOP'97. CONFERENCE PROCEEDINGS, PROCEEDINGS OF OOP'97. OBJEKT ORIENTIERTES PROGRAMMIEREN, MUCHEN, GERMANY, 3-7 FEB. 1997, 1997, Bergisch Gladbach, Germany, SIGS Conferences, Germany, pages 269 - 274, XP002082818**

**Description**

TECHNICAL FIELD

The present inventive concept relates, in general, to a device for emitting light and a method for producing a light-emitting device.

BACKGROUND

A semiconductor diode such as a light-emitting diode (LED), or a laser diode may form a light-emitting device. Such light-emitting devices are used in a variety of applications, e.g. 3D printing. An example of a semiconductor diode is disclosed in EP 1 959 530 A1.

SUMMARY

It is an objective to provide a light-emitting device having a high output power. It is a further objective of the present inventive concept to provide a light-emitting device emitting ultraviolet (UV) light. Another objective is to increase the electron and hole carrier injection for light-emission in light-emitting GaN devices.

These and other objectives of the inventive concept are at least partly met by the invention as defined in the independent claims. Preferred embodiments are set out in the dependent claims.

In some embodiments, a high-power laser is provided. Carbon dioxide lasers are still expensive to use, hence alternative light-emitting diode heterostructure laser diodes is an interesting alternative that can be mass-produced at scale. However, laser diodes for 3D printing is currently limited to power less than 100W. Since the very beginning of the development of nitride based laser diode technology, it has been hampered by the problem of poor crystalline quality of epitaxial layers constituting the active areas of these devices. The problem is related to the lack of an adequate substrate material which would match GaN both in terms of lattice parameters and thermal expansion coefficient.

According to a first aspect of the invention, there is provided a device for emitting light, the device comprising:

a substrate;
a base layer arranged on the substrate, the base layer comprising $Al(x)Ga(1-x)N$ wherein $0 < x \leq 1$;
a diode layer structure arranged on the base layer, the diode layer structure comprising a quantum well layer structure sandwiched between an n-doped semiconductor layer and a p-doped semiconductor layer;
the quantum well layer structure comprising a first and second quantum well, a first and a second proximal barrier layer, and a first and a second distal barrier layer,
wherein the first and second quantum well each has a thickness below 5 nm and a bandgap smaller than bandgaps of the first and second proximal barrier layers;
wherein the first and second proximal barrier layer each comprises intrinsically doped GaN, wherein the first and second quantum wells are sandwiched between the first and second proximal barrier layers, wherein the first and second distal barrier layer each comprises $Al(a)Ga(1-a)N$ wherein $0 < a \leq 0.3$, wherein the first and second quantum wells and the first and second proximal barrier layers are sandwiched between the first and second distal barrier layers;
wherein the n-doped semiconductor layer is configured to inject electrons into the quantum well layer structure;
wherein the p-doped semiconductor layer is configured to inject holes into the quantum well layer structure, preferably wherein said base layer is AlN having a thickness 100-500 nm.

According to the above, the device emits light when forward biased. The n-doped semiconductor layer may be configured to inject electrons into the quantum well layer structure when the diode layer structure is forward biased. The n-doped semiconductor layer may have a doping level above $1 \times 10^{10}$ cm$^{-3}$. The n-doped semiconductor layer may comprise an $Al(y)Ga(1-y)N$ layer, wherein $0 \leq y \leq 0.5$. The p-doped semiconductor layer may be configured to inject holes into the quantum well layer structure when the diode layer structure is forward biased. The p-doped semiconductor layer may have a doping level above $1 \times 10^{15}$ cm$^{-3}$. Electrons and holes injected into the quantum well layer structure recombine in the first and second quantum well of the quantum well layer structure whereby the device emits light.

The first and second quantum well may be InGaN quantum wells and may thus have a bandgap smaller than the bandgap of the GaN proximal barrier layers. Consequently, charge carriers, i.e. electrons and holes, may be confined in the first and second quantum well by the proximal barrier layers. Charge carriers may additionally be confined in the first and second quantum well by the distal barrier layers. The distal barrier layers may have a larger bandgap than the proximal barrier layers. Further, the distal barrier layers may have a larger bandgap than the n- and p-doped semiconductor layers. Thus, the distal barrier layers may act as barriers, such as tunnel barriers, between the quantum wells and the layers injecting the charge carriers.

Further, it is advantageous to avoid dopants in the vicinity of the quantum wells. Such dopants may act as, or create, non-radiative pathways for the charge carriers in the first and second quantum well. Therefore, it is advantageous to sandwich the first and second quantum wells between the proximal barrier layers of intrinsically doped GaN. The term intrinsically doped GaN refers to GaN which is not intentionally doped e.g. by silicon donor atoms for n-type GaN or magnesium acceptor atoms for p-type GaN, such as GaN wherein both the electron and hole carrier concentrations are below $5 \times 10^{16}$ cm$^{-3}$ at room temperature. Intentionally doping of GaN may be performed in-situ during GaN growth. Further, the distal barrier layers may separate charge carriers in the first and second quantum wells from the dopants in the n- and p-doped semiconductor layers. Thus, charge carriers may be injected into the first and second quantum well, e.g. by tunneling through the distal barrier layers, and be trapped in the first and second quantum well wherein the charge carriers are prevented from returning to donor atoms of the n-doped semiconductor layer or to acceptor atoms of the p-doped semiconductor layer. However, the quantum well layer structure may be configured to allow tunneling of charge carriers between the first and second quantum well. For example, the first and second quantum well may be separated by a barrier layer, e.g. a GaN barrier layer, sufficiently thin to allow tunneling. The barrier layer between the first and second quantum well may have a thickness below 30 nm, preferably below 10 nm. Thus, the first and second quantum well may be quantum mechanically coupled, e.g. tunnel coupled. Such quantum wells may emit strongly such that the device has a high output power. Additionally, there may be further advantages. As one example, the emission spectrum may be tailored by the barrier thickness between the first and second quantum well. As another example, the emission wavelength may be tunable by an electric field applied between the first and second quantum well.

It is a further realization that a high conductivity of charge carriers to the first and second quantum well enables a high output power. The current continuity equation is the equation

$$\frac{\partial n}{\partial t} = \frac{1}{q}\frac{dJ}{dt} - U(n,p)$$

where n is charge carrier concentration, q is the elementary charge, J is the current density, and U(n,p) is the net recombination rate. Hence, charge entering into the first and second quantum well must emerge at the other side, be trapped, or be neutralized by recombination. Hence, when a high conductivity, such as a high injection mobility, is achieved, the recombination and hence the light-emission or power becomes high. By separating the first and second quantum well from the n- and p-doped semiconductor layers, by the proximal barrier layers, a high injection mobility, is achieved. For example, with a low concentration of dopant atoms in a proximal barrier layer, e.g. an intrinsically doped proximal barrier layer, a charge carrier may travel through the proximal barrier layer ballistically, i.e. without scattering. Thus, a charge carrier may travel through the proximal barrier layer very fast and thereby enable a high output power.

Further, the device may be configured such that a conduction band edge of the n-doped semiconductor layer has a higher energy than a conduction band edge of the proximal barrier layer into which the n-doped semiconductor layer injects electrons. Thus, the energy difference may be converted into kinetic energy for the injected electron which subsequently travels to the first and second quantum well faster.

Further, the device may be configured such that a valence band edge of the p-doped semiconductor layer has a lower energy than a valence band edge of the proximal barrier layer into which the p-doped semiconductor layer injects holes. Thus, the energy difference may be converted into kinetic energy for the injected holes which subsequently travels to the first and second quantum well faster.

It is a realization that a high crystalline quality of the first and second quantum well enables a high output power as a high crystalline quality leads to few non-radiative recombination centers and/or a high quantum efficiency of the device. By separating the first and second quantum well from the n- and p-doped semiconductor layers, by the proximal and distal barrier layers, a high crystalline quality of the first and second quantum well is enabled. Further, the use of a base layer between the substrate and the diode layer structure enables a high crystalline quality of the diode layer structure, in particular a high crystalline quality of the first and second quantum wells. The substrate may have a lattice mismatch to the diode layer structure as nitride based substrates are expensive. Thus, the substrate may be a silicon substrate, a sapphire substrate, or a silicon carbide substrate. The base layer may herein prevent or reduce formation of dislocations that may act as non-radiative recombination centers. The base layer may prevent dislocations from spreading into the diode layer structure, in particular prevent dislocations from spreading into the first or second quantum well. It is herein particularly advantageous if the base layer comprises an AlN layer, e.g. an AlN layer directly on the substrate. Said AlN layer may comprise sputtered AlN which is particularly advantageous for reducing the risk of dislocations. The base layer may comprise base layer pillars, the base layer pillars being pillars arranged perpendicular to the substrate. The base layer pillars may comprise AlN, e.g. sputtered AlN. It is a realization of the inventor that AlN processing in MOCVD, as used for GaN buffer layers on e.g. silicon or sapphire substrates, is a severely contaminating process for InGaN quantum wells. The base layer may hence be provided ex-situ of the MOCVD process. The base layer pillars may have a diameter smaller than 500 nm, such as smaller than 100 nm. The base layer pillars may be laterally encased in base layer encasing material, such as $Al_xGa_{1-x}N$, wherein $0 \leq x \leq 0.95$. The $Al_xGa_{1-x}N$ laterally encasing the base layer pillars may comprise dislocations laterally propagating from the base layer pillars. Thus, the base layer may lock in dislocations by the dislocations preferentially propagating laterally from the base layer pillars, such that the dislocations do not reach the diode layer structure.

The quantum well layer structure may be configured to be substantially doped by a distal n-doped semiconductor layer and a distal p-doped semiconductor layer for recombination of electrons and holes by bending of the energy bands due to the difference in band gaps of the adjacent layers. The band gap of AlN is 6.015 eV and that of GaN is 3.4 V at room temperature. The band gap of the distal barrier may be configured to separate the donor atoms from electrons and acceptor atoms from electron holes. The distal barrier may be an AlGaN alloy provided as a potential energy barrier for confining charge carriers to the quantum well by preventing tunnelling from the quantum well whereas the proximal barrier may be configured for allowing substantial tunnelling between quantum wells. Due to the potential energy well formed, the charge carriers may be confined in a 2-dimensional gas at the heterostructure interfaces that can tunnel to adjacent quantum wells. Both the thickness of the distal barrier and its aluminum concentration may be configured for optimizing the electroluminescence from the quantum well layer structure. It is advantageous to dope the quantum well layer structure by distal layers as the dopants may be separated from the quantum well layer structure and hence reduce Coulomb potentials from altering the potential energy well provided by the quantum well layer structure.

The distal n-doped semiconductor layer for doping the quantum well layer structure may be the n-doped semiconductor layer configured to inject electrons into the quantum well layer structure. Thus, this layer may both dope the quantum well layer structure and inject electrons into the quantum well layer structure. Alternatively, the distal n-doped semiconductor layer for doping the quantum well layer structure may be different from the n-doped semiconductor layer configured to inject electrons into the quantum well layer structure.

The distal p-doped semiconductor layer for doping the quantum well layer structure may be the p-doped semiconductor layer configured to inject holes into the quantum well layer structure. Thus, this layer may both dope the quantum well layer structure and inject holes into the quantum well layer structure. Alternatively, the distal p-doped semiconductor layer for doping the quantum well layer structure may be different from the p-doped semiconductor layer configured to inject holes into the quantum well layer structure.

The quantum well layer structure of the diode layer structure may comprise a plurality of quantum wells, wherein adjacent quantum wells of the plurality of quantum wells are separated by a barrier layer having a thickness less than 10 nm. The quantization of the layers is perpendicular to the growth direction of GaN, that may be the C-direction on a silicon (111) wafer. For example, the quantum well layer structure may be sufficiently thin to confine charge carriers to a quantum state as a 2-dimensional gas and comprise more than two quantum wells, such as 5 quantum wells or 10 quantum wells. The thickness of the separating barrier may be the same for all pairs of adjacent quantum wells or different for different pairs of adjacent quantum wells each having thickness of 1-5 nm.

The plurality of quantum wells may quantum mechanically couple to each other, e.g. by tunnel coupling. Thus, the plurality of quantum wells may form minibands of energy levels. Such minibands may emit strongly such that the device has a high output power. Further the emission spectrum may be tailored by the barrier thickness between adjacent quantum wells.

The p-doped semiconductor layer may comprise a superlattice of GaN layers and $Al(z)Ga(1-z)N$ layers, wherein $0 < z \leq 1$, wherein the $Al(z)Ga(1-z)N$ layers of the superlattice are p-doped.

It is a realization that the superlattice may enhance the doping in the p-doped semiconductor layer that injects holes into the quantum well layer structure. Alternatively, the superlattice may remove or reduce the need for post-growth annealing of the p-doped semiconductor layer that injects holes into the quantum well layer structure.

P-doping may be hard to achieve in GaN based materials. Doping atoms, such as Mg, used for p-doping are often passivated by hydrogen impurities or nitrogen vacancies. Therefore, the free hole concentration may be low even if the doping concentration is high. To remove the passivation (or activate the doping atoms), post-growth annealing may be used, e.g. post-growth annealing in an atmosphere of low hydrogen concentration.

The superlattice may enhance the p-doping through a variation in the valence-band edge, as described by Kozodoy et al. [Appl. Phys. Lett. 75, 2444 (1999)]. The variation in the valence-band edge is herein caused by the variation in Al content in the superlattice where the $Al(z)Ga(1-z)N$ layers of the superlattice have a higher Al content than the GaN layers of the superlattice. Acceptors may be ionized where the band edge is far below the Fermi energy and the resulting holes may accumulate where the band edge is close to the Fermi level. The valence-band edge may herein vary in a direction perpendicular to the layers of the superlattice. As a consequence of the variation in the valence-band edge, the hole concentration may also vary. However, the average hole concentration may be higher than in a bulk film wherein the valence-band edge does not vary. It should be understood that the variation in the valence-band edge may be due to a varying bandgap in the superlattice as well as polarization effects due to band bending. The superlattice may also enhance the hole mobility, as further described by Kozodoy et al. [Appl. Phys. Lett. 75, 2444-2446 (1999)].

The GaN layers of the superlattice of the p-doped semiconductor layer may advantageously be intrinsically doped. Alternatively, the GaN layers of the superlattice of the p-doped semiconductor layer may be p-doped.

Similarly, the n-doped semiconductor layer may comprise a superlattice of GaN layers and Al(z)Ga(1-z)N layers, wherein 0 < z ≤ 1, wherein the Al(z)Ga(1-z)N layers of the superlattice are n-doped.

It is a realization that similar enhancement effects as for the p-doped semiconductor layer may be achieved for the n-doped semiconductor layer by the use of a superlattice.

The GaN layers of the superlattice of the n-doped semiconductor layer may advantageously be intrinsically doped. Alternatively, the GaN layers of the superlattice of the n-doped semiconductor layer may be n-doped.

The device may further comprise a via, the via being a metal contact going through the substrate and electrically connecting to the n-doped semiconductor layer or to the p-doped semiconductor layer of the diode layer structure.

Thus, if the bottom charge carrier injecting layer is the n-doped semiconductor layer and the top charge carrier injecting layer is the p-doped semiconductor layer (i.e. if the n-doped semiconductor layer is closer to the substrate than the p-doped semiconductor layer) then the n-doped semiconductor layer may be electrically contacted by the via and the p-doped semiconductor layer may be electrically contacted by a top contact.

Similarly, if the bottom charge carrier injecting layer is the p-doped semiconductor layer and the top charge carrier injecting layer is the n-doped semiconductor layer (i.e. if the p-doped semiconductor layer is closer to the substrate than the n-doped semiconductor layer) then the p-doped semiconductor layer may be electrically contacted by the via and the n-doped semiconductor layer may be electrically contacted by a top contact.

Consequently, lateral currents to the bottom charge carrier injecting layer may be avoided. Further, if a plurality of devices are arranged on the same chip, said plurality of devices may be densely packed when vias to the bottom charge carrier injecting layer are used.

The device may be further configured such that:

the n-doped semiconductor layer comprises a pillar layer, the pillar layer of the n-doped semiconductor layer comprising at least one n-doped semiconductor pillar embedded in supporting material, wherein the at least one n-doped semiconductor pillar is configured to form an electron transport channel through the pillar layer of the n-doped semiconductor layer to the quantum well layer structure; and/or the p-doped semiconductor layer comprises a pillar layer, the pillar layer of the p-doped semiconductor layer comprising at least one p-doped semiconductor pillar embedded in supporting material, wherein the at least one p-doped semiconductor pillar is configured to form a hole transport channel through the pillar layer of the p-doped semiconductor layer to the quantum well layer structure.

A n-doped semiconductor pillar may e.g. be a n-doped GaN pillar, e.g. a n-doped GaN nanowire. A p-doped semiconductor pillar may e.g. be a p-doped GaN pillar, e.g. a p-doped GaN nanowire.

It is a realization that a semiconductor pillar may guide the charge carriers effectively to the quantum well layer structure. Thus, a high conductivity may be achieved for the injected charge carriers. A semiconductor pillar exhibiting quantum confinement may be particularly useful as it may enable ballistic transport of charge carriers to the quantum well layer structure. Thus, the at least one semiconductor pillar may have a diameter smaller than 500 nm. In particular, the at least one semiconductor pillar may have a diameter smaller than 100 nm. In particular, the at least one semiconductor pillar may be a nanowire. As previously mentioned, ballistic transport of charge carriers may enable charge carriers to travel very fast and thereby enable a high output power and reduce scattering of charge carriers.

For one or more pillar layers of the device, the supporting material may be a semiconductor material with a doping opposite to the doping of the semiconductor pillars embedded in said supporting material.

Thus, for a n-doped semiconductor layer a semiconductor pillar of the pillar layer may be n-doped and the supporting material may be p-doped. Consequently, electrons injected by the n-doped semiconductor layer may be forced to travel through the n-doped semiconductor pillars.

Thus, for a p-doped semiconductor layer a semiconductor pillar of the pillar layer may be p-doped and the supporting material may be n-doped. Consequently, holes injected by the p-doped semiconductor layer may be forced to travel through the p-doped semiconductor pillars.

The supporting material may be iron-doped or carbon-doped GaN, e.g. in the case where a semiconductor pillar of the pillar layer is n-doped. Iron or carbon dopants may act as deep acceptor dopants which compensate undesirable shallow donors and residual impurities in the GaN. The use of iron-doped or carbon-doped GaN supporting material makes it possible to grow enhanced quality material on top of or after the pillar layer, e.g. in a quantum well layer structure grown after the pillar layer.

Alternatively, or additionally, for one or more pillar layers of the device, the supporting material may be a gallium oxide or in-situ $Si_3N_4$.

The gallium oxide may be e.g. $Ga_2O$ or $Ga_2O_3$. Gallium oxide has a large bandgap and may thereby facilitate effective confinement of the charge carriers to the semiconductor pillars.

Further, for one or more pillar layers of the device, a diameter of the semiconductor pillars may be 10-500 nm and a pitch of the semiconductor pillars may be 200-500 nm. Such a configuration enables a good confinement of the charge carriers to the semiconductor pillars and at the same time a sufficient current density through the pillar layer.

A charge carrier concentration for light holes may be provided in the p-doped semiconductor layer by strain. For example, strain may raise the light hole band energy above the heavy hole band energy. Thus, conduction through mainly light holes may be facilitated which may lead to fast injection of holes and thereby a high output power. For example, the p-doped semiconductor layer may comprise a pillar layer wherein the semiconductor pillars of the pillar layer are strained by the supporting material such that the light hole bands of the semiconductor pillars have a higher energy than the heavy hole bands of the semiconductor pillars.

The device may be a vertical-cavity surface emitting laser (VCSEL) comprising a bottom reflector below the first and second quantum wells and a top reflector above the first and second quantum wells, the top and bottom reflector forming an optical resonator for light emitted by the first and second quantum wells.

The bottom and top reflector may respectively be distributed Bragg reflectors (DBRs). A DBR may comprise layers of alternating high and low refractive index. The thicknesses of the layers may be configured to correspond to a quarter of the emission wavelength, e.g. a quarter of the wavelength of the light emitted by the quantum wells of the quantum well layer structure.

If the p-doped semiconductor layer comprises a superlattice of GaN layers and Al(z)Ga(1-z)N layers, said superlattice may also form part of a DBR of the VCSEL.

If the n-doped semiconductor layer comprises a superlattice of GaN layers and Al(z)Ga(1-z)N layers, said superlattice may also form part of a DBR of the VCSEL.

An optical resonator for light emitted by the first and second quantum wells may be formed by the top and bottom reflector having a separation corresponding to a resonance wavelength similar to the wavelength of the emission from the first and second quantum wells. Said resonance wavelength of the optical resonator may be within ±20% of the wavelength of the emission from the first and second quantum wells.

As described above, it may be particularly advantageous when charge carriers, i.e. electrons and holes, are confined in the quantum wells by both proximal barrier layers and distal barrier layers. For example, when both the first and the second distal barrier layer have larger bandgaps than the first and second proximal barrier layers. In such a situation, the distal barrier layers may form energy barriers for holes on both sides of the region sandwiched between the distal barrier layers. Similarly, in such a situation, the distal barrier layers may form energy barriers for electrons on both sides of the region sandwiched between the distal barrier layers. Accordingly, both electrons and holes may be confined in a two-step structure. Electrons and holes may be firstly confined, by the proximal barrier layers, in the quantum wells. Electrons and holes may be secondly confined, by the distal barrier layers, in the region sandwiched between the distal barrier layers. Such a structure, which confines both electrons and holes by distal barrier layers, advantageously improves the electroluminescence.

As described above, it may be particularly advantageous to have a lower aluminum content in the proximal barrier layers than in the distal barrier layers as this may prevent diffusion of aluminum into the quantum wells, which may deteriorate the performance.

Hereinafter, further examples are given of a structure where both the first and the second distal barrier layer have larger bandgaps than the first and second proximal barrier layers. The first and the second distal barrier layer may each have a bandgap larger than the bandgap of GaN. Thus, the first and the second distal barrier layer may each comprise Al(a)Ga(1-a)N wherein $0 < a \leq 0.3$, such as e.g. $0.1 < a \leq 0.3$. Further, the first and second proximal barrier layers may each have a thickness below 50 nm, such as a thickness below 10 nm. Such thicknesses may provide an advantageous relation between confinement from proximal barrier layers and distal barrier layers. The quantum well section of the structure (comprising the quantum wells sandwiched between the first and the second proximal barrier layer, e.g. the thickness from the first to the last quantum well) may have a thickness below 20-100 nm.

An advantageous structure may be (layers described from bottom to top):

- Substrate;
- Base layer comprising Al(x)Ga(1-x)N wherein $0 < x \leq 1$;
- n-doped layer, e.g. n-doped GaN;
- First distal barrier layer of Al(a)Ga(1-a)N wherein $0 < a \leq 0.3$, such as e.g. $0.1 < a \leq 0.3$. The first distal barrier layer may be intrinsic, alternatively it may be doped. The thickness of the first distal barrier layer may be below 10 nm;
- First proximal barrier layer of intrinsically doped GaN. The thickness of the first distal barrier layer may be below 50 nm, such as below 10 nm;
- First and second quantum well, each quantum well having a thickness below 5 nm. The quantum wells may be separated by e.g. a GaN barrier layer with a thickness below 20 nm, such as below 5 nm.
- Second proximal barrier layer of intrinsically doped GaN. The thickness of the second distal barrier layer may be below 10 nm, such as below 5 nm;
- Second distal barrier layer of Al(a)Ga(1-a)N wherein $0 < a \leq 0.3$, such as e.g. $0.1 < a \leq 0.3$. The second distal barrier layer may be intrinsic, alternatively it may be doped. The thickness of the first distal barrier layer may be below 20 nm such as below 10 nm;
- p-doped layer, e.g. p-doped GaN;

In particular, an advantageous structure may be (layers described from bottom to top):

- Substrate;
- Base layer comprising Al(x)Ga(1-x)N wherein $0 < x \leq 1$;

- n-doped layer of n-doped GaN;
- First distal barrier layer of less than 10 nm Al(a)Ga(1-a)N wherein $0.1 < a \le 0.3$;
- First proximal barrier layer of intrinsically doped GaN. The thickness of the first distal barrier layer may be below 50 nm, such as below 10 nm;
- First and second quantum well of InGaN, each quantum well having a thickness below 5 nm. The quantum wells may be separated by e.g. a GaN barrier layer with a thickness below 30 nm, such as below 10 nm.
- Second proximal barrier layer of intrinsically doped GaN. The thickness of the second distal barrier layer may be below 50 nm, such as below 10 nm;
- Second distal barrier layer of less than 10 nm Al(a)Ga(1-a)N wherein $0.1 < a \le 0.3$;
- p-doped layer of p-doped GaN;

In the above structures, the n-doped and the p-doped layer may swap places.

In the above structures, there may be more than two quantum wells between the first and second proximal barrier layers.

According to a second aspect of the invention there is provided a method for producing a light-emitting device, the method comprising:

providing a substrate;
depositing, by physical vapor deposition, a base layer on the substrate, the base layer comprising Al(x)Ga(1-x)N;
forming a diode layer structure on the base layer, the diode layer structure comprising a quantum well layer structure sandwiched between an n-doped semiconductor layer and a p-doped semiconductor layer,
the quantum well layer structure comprising a first and second quantum well, a first and a second proximal barrier layer, and a first and a second distal barrier layer,
wherein the first and second quantum well each has a thickness below 5 nm and a bandgap smaller than bandgaps of the first and second proximal barrier layers;
wherein the first and second proximal barrier layer each comprises intrinsically doped GaN, wherein the first and second quantum wells are sandwiched between the first and second proximal barrier layers, wherein the first and second distal barrier layer each comprises Al(a)Ga(1-a)N wherein $0 < a \le 0.3$, wherein the first and second quantum wells and the first and second proximal barrier layers are sandwiched between the first and second distal barrier layers;
wherein the n-doped semiconductor layer is configured to inject electrons into the quantum well layer structure;
wherein the p-doped semiconductor layer is configured to inject holes into the quantum well layer structure, preferably wherein said base layer is AlN having a thickness 100-500 nm.

Accordingly, the base layer is deposited by physical vapor deposition, e.g. by sputtering. The layers of the diode layer structure may then be formed by epitaxial growth on the base layer.

A light-emitting device produced according to the second aspect may have the same advantages, or similar advantages, as the device according to the first aspect and may possibly be the subject of a future divisional application.

The method may further comprisine:

etching a hole through the substrate by reactive ion etching; and
depositing metal in the hole through the substrate such that a metal contact is formed, the metal contact going through the substrate and electrically connecting to the n-doped semiconductor layer or to the p-doped semiconductor layer of the diode layer structure.

Thus, a via may be formed. Reactive ion etching may be particularly suitable for etching deep holes such as a hole through the substrate. The reactive ion etching may be chlorine reactive ion etching.

The etching of the hole through the substrate by reactive ion etching may be ended based on spectroscopically detecting molecular species of aluminum chloride or aluminum fluoride.

When etching deep holes, such as a hole through the substrate, it may be hard to know the exact etch depth. It is a realization that a spectroscopic signal of aluminum chloride or aluminum fluoride may indicate that the reactive ion etching has gone through the substrate, e.g. through a silicon substrate, and reached the Al(x)Ga(1-x)N of the base layer. The molecular species may e.g. be spectroscopically detected by UV-vis spectroscopy.

Spectroscopic signals may be used as triggering for the etch that is stopped upon reaching the etch completion i.e. breakthrough of an AlN or an aluminum-containing Al(x)Ga(1-x)N base layer whereby the signal intensity from the AlN is reduced. The plasma etch may be performed with an ICP plasma etch. An advantage of the method is that the same base layer may be used for growing GaN of high quality on silicon as used to define a trench for the drain contact of the device.

BRIEF DESCRIPTION OF THE DRAWINGS

The above, as well as additional objects, features and advantages of the present invention, will be better understood through the following illustrative and non-limiting detailed description, with reference to the appended drawings. In the drawings like reference numerals will be used for like elements unless stated otherwise.

Fig. 1 illustrates a light-emitting device
Fig. 2 illustrates band structure
Fig. 3 illustrates a quantum well layer structure
Fig. 4 illustrates a charge carrier injecting layer
Fig. 5 illustrates a charge carrier injecting layer
Fig. 6 illustrates a charge carrier injecting layer
Fig. 7 illustrates a charge carrier injecting layer
Fig. 8 illustrates a charge carrier injecting layer
Fig. 9 illustrates a base layer
Fig. 10 illustrates a vertical-cavity surface emitting laser
Fig. 11 is a flow chart of a method

DETAILED DESCRIPTION

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

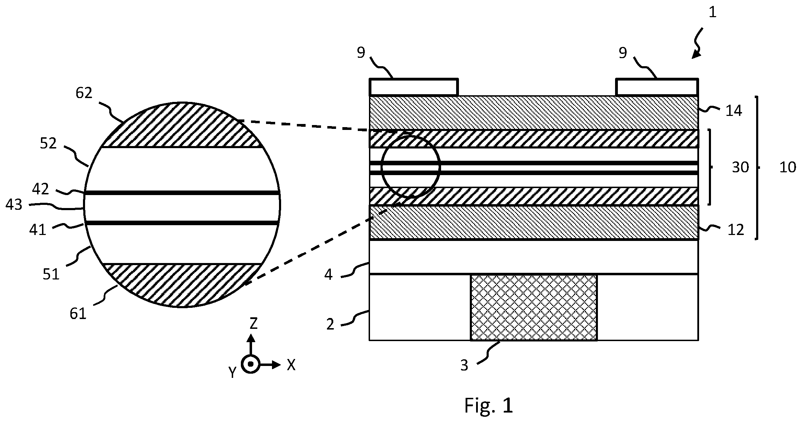

Fig. 1 illustrates a cross-sectional view of a device 1 for emitting light. The device comprises a substrate 2, a base layer 4 arranged on the substrate 2, and a diode layer structure 10 arranged on the base layer 4.

The substrate 2 may be a semiconductor wafer or part of a semiconductor wafer. The substrate 2 may be e.g. a silicon substrate 2, a sapphire substrate 2, or a silicon carbide substrate 2. A silicon substrate 2 is preferred due its low cost. The substrate 2 may extend in a plane, hereinafter called the XY plane. The different layers of the device 1 may be arranged on top of the substrate 2, one after the other, in a direction normal to the XY plane, said direction is hereinafter called the Z direction. It should be understood that the illustrations of devices 1 herein are schematic illustrations. The devices 1 generally have substantially larger dimensions in the X and Y directions of the XY plane than in the Z direction.

The base layer 4 and diode layer structure 10 may comprise nitride-based semiconductor material.

The base layer 4 comprises $Al(x)Ga(1-x)N$, wherein $0 < x \leq 1$. It is preferred that the base layer 4 comprises a 100-500 nm thick AlN layer, i.e. a layer where x=1, i.e. a layer where the Al content is 100%. Said AlN layer is preferably arranged directly on the substrate 2, e.g. directly on a silicon substrate 2. Said AlN layer preferably comprises AlN deposited by physical vapor deposition. Said AlN layer may e.g. comprise sputtered AlN. Alternatively, or additionally, the base layer 4 may comprise sputtered layers of other Al compositions.

The base layer 4 may comprise a single layer or a plurality of layers. For example, the base layer may comprise a AlN layer arranged directly on the substrate 2 followed by one or more $Al(x)Ga(1-x)N$ layers with lower Al content, i.e. x<1. The base layer 4 may further comprise base layer pillars 6, as discussed below.

The base layer 4 may comprise epitaxially grown layers. For example, the base layer 4 may comprise at least one epitaxially grown layer between a sputtered layer and the diode layer structure 10. The base layer 4 may prevent or reduce formation of dislocations and/or prevent dislocations from spreading into the diode layer structure 10.

The diode layer structure 10 is, as mentioned, arranged on the base layer 4. The diode layer structure 10 may comprise nitride-based semiconductor material. The diode layer structure comprises a quantum well layer structure 30 sandwiched between an n-doped semiconductor layer 12 and a p-doped semiconductor layer 14. In Fig. 1 the order of the layers in the diode layer structure 10 is, counted from the base layer 4 in the Z direction: the n-doped semiconductor layer 12 followed by the quantum well layer structure 30 followed by the p-doped semiconductor layer 14. Alternatively, the order may be reversed, i.e. the p-doped semiconductor layer 14 followed by the quantum well layer structure 30 followed by the n-doped semiconductor layer 12. The n-doped semiconductor layer 12 acts as a charge carrier injecting layer which injects electrons into the quantum well layer structure 30 when the diode layer structure 10 is forward biased. Similarly, the p-doped semiconductor layer 14 acts as a charge carrier injecting layer which injects holes into the quantum well layer structure 30 when the diode layer structure 10 is forward biased.

The quantum well layer structure 30 comprises a first 41 and second quantum well 42, a first 51 and a second 52 proximal barrier layer, and a first 61 and a second 62 distal barrier layer. The first 41 and second 42 quantum wells may be separated by a barrier layer 43. The first 41 and second 42 quantum wells are sandwiched between the first 51 and second 52 proximal barrier layers. The first 41 and second 42 quantum wells and the first 51 and second 52 proximal barrier layers are sandwiched between the first 61 and second 62 distal barrier layers. Thus, the order of the layers in the quantum well layer structure 30 may be, counted from the bottom charge carrier injecting layer in the Z direction: first distal barrier layer 61, first proximal barrier layer 51, first quantum well 41, barrier layer 43, second quantum well 42, second proximal barrier layer 52, second distal barrier layer 62.

The first 41 and second 42 quantum well each has a thickness below 5 nm and a bandgap smaller than bandgaps of the first 51 and second 52 proximal barrier layers. The first 41 and second 42 quantum well may be InAlGaN layers or InGaN layers. For example, the first 41 and second 42 quantum well may be $In(b)Al(c)Ga(1-b-c)N$ layers wherein $0 \leq b \leq 1$ and $0 \leq c \leq 1$. The first 41 and second 42 quantum well may have the same composition or different compositions. The barrier 43 between the first 41 and second 42 quantum well may have a bandgap larger than the bandgaps of the first 41 and second 42 quantum wells. The barrier 43 between the first 41 and second 42 quantum well may be a GaN layer, e.g. an intrinsically doped GaN layer. The barrier layer 43 between the first 41 and second 42 quantum well may have a thickness below 30 nm, preferably below 10 nm.

The first 51 and second 52 proximal barrier layer each comprises intrinsically doped GaN. The first 61 and second 62 distal barrier layer each comprises Al(a)Ga(1-a)N wherein $0 < a \leq 0.3$. This provides a good barrier for separating charge carriers in the first 41 and second 42 quantum wells from the dopants in the n- 12 and p-doped 14 semiconductor layers.

The device 1 may further comprise electrical contacts for biasing and/or providing charge carriers for the diode layer structure 10. As illustrated in Fig. 1 the device 1 may comprise a top contact 9 electrically connected to the top charge carrier injecting layer and a via 3 electrically connected to the bottom charge carrier injecting layer. In Fig. 1 the top contact 9 is electrically connected to the p-doped semiconductor layer 14 and the via 3 is electrically connected to the n-doped semiconductor layer 12. The via 3 is a metal contact going through the substrate 2.

The via 3 may electrically connect to the bottom charge carrier injecting layer e.g. by forming an ohmic contact with the bottom charge carrier injecting layer. Thus, the via 3 may extend through the substrate 2 and through the base layer 4 to reach the bottom charge carrier injecting layer.

Alternatively, the via 3 may electrically connect to the bottom charge carrier injecting layer through one or more intermediate layers. There may be one or more intermediate layers between the via 3 and the bottom charge carrier injecting layer, wherein the one or more intermediate layers have the same doping type (n or p) as the bottom charge carrier injecting layer. Thus, the via may form an ohmic contact with the bottom intermediate layer and thereby be electrically connected to the bottom charge carrier injecting layer through the intermediate layers. Fig. 1 illustrates the situation where the base layer 4 acts as an intermediate layer between the via 3 and the bottom charge carrier injecting layer which in this case is the n-doped semiconductor layer 12.

The device 1 may be configured to emit light in the vertical direction, i.e. the Z direction. The light may herein be emitted through an aperture through the top contact 9, as illustrated in Fig. 1, or by the top contact 9 being semi-transparent. Thus, the device 1 may be a VCSEL 70.

Alternatively, the device 1 may be configured to emit light in a lateral direction, e.g. the X or Y direction. The light may herein be emitted at a lateral edge of the diode layer structure 10. Thus, the device 1 may be an edge-emitting laser.

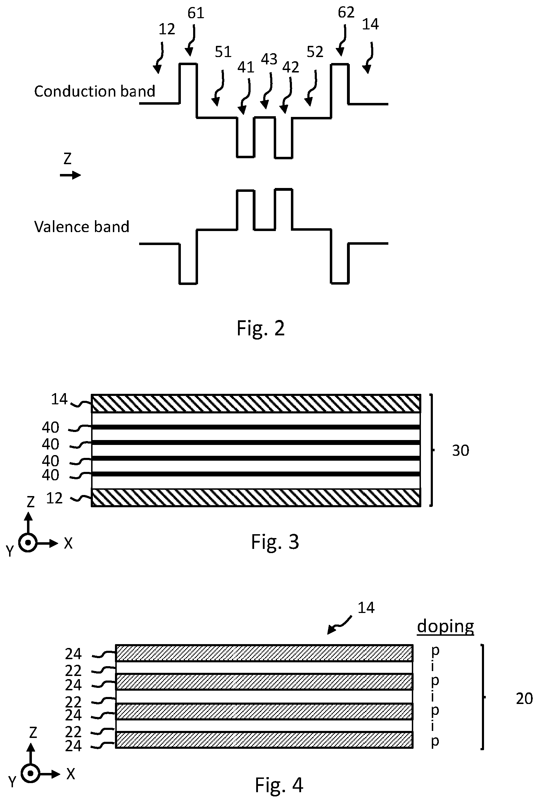

An example of a semiconductor band structure of the diode layer structure 10 is seen in Fig. 2. As illustrated, a distal barrier layer 61, 62 may have a larger bandgap than the charge carrier injecting layer 12, 14 to which said distal barrier layer 61, 62 borders. Thus, the distal barrier layer 61, 62 may form a tunneling barrier through which charge carriers tunnel when they are injected into the quantum well layer structure 30. Distal barrier layers 61, 62 which form tunneling barriers may be configured to have a thickness sufficiently thin for charge carrier tunneling. For example, such a tunneling barrier may be thinner than 30 nm, e.g. thinner than 10 nm. As an alternative, a distal barrier layer 61, 62 may have a smaller bandgap than the charge carrier injecting layer 12, 14 to which said distal barrier layer 61, 62 borders. In this case, charge carriers may be injected into the quantum well layer structure 30 without tunneling.

The quantum well layer structure 30 may be configured to be substantially doped by a distal n-doped semiconductor layer and a distal p-doped semiconductor layer for recombination of electrons and holes. For example, the distal n-doped semiconductor layer for doping the quantum well layer structure 30 may be arranged less than 50 nm from a quantum well 41, 42 of the quantum well layer structure 30. Similarly, the distal p-doped semiconductor layer for doping the quantum well layer structure 30 may be arranged less than 50 nm from a quantum well 41, 42 of the quantum well layer structure 30.

The quantum well layer structure 30 may comprise more than two quantum wells 40. The quantum well layer structure 30 of the diode layer structure 10 may comprise a plurality of quantum wells 40, wherein adjacent quantum wells 40 of the plurality of quantum wells 40 are separated by a barrier layer having a thickness less than 10 nm. Fig. 3 illustrates a cross-sectional view of a quantum well layer structure 30 comprising four quantum wells 40.

A charge carrier injecting layer of the device 1 may comprise a superlattice 20. This may enhance the doping of said charge carrier injecting layer.

For example, the p-doped semiconductor layer 14 may comprise a superlattice 20 of GaN layers 22 and Al(z)Ga(1-z)N layers 24, wherein $0 < z \leq 1$, wherein the Al(z)Ga(1-z)N layers 24 of the superlattice 20 are p-doped.

Similarly, the n-doped semiconductor layer 12 may comprise a superlattice 20 of GaN layers 22 and Al(z)Ga(1-z)N layers 24, wherein $0 < z \leq 1$, wherein the Al(z)Ga(1-z)N layers 24 of the superlattice 20 are n-doped.

Fig. 4 illustrates a cross-sectional view of a charge carrier injecting layer, in this case a p-doped semiconductor layer 14, comprising a superlattice 20 of GaN layers 22 and Al(z)Ga(1-z)N layers 24. In this figure and in the following figures the doping of each layer is indicated next to each layer. Herein, p stands for p-doping, i stands for intrinsic doping, and n stands for n-doping. As illustrated in Fig. 4, the GaN layers 22 may be intrinsically doped. This may apply to superlattices 20 of p-doped semiconductor layers 14 as well as to superlattices 20 of n-doped semiconductor layers 12.

Preferably the Al(z)Ga(1-z)N layers 24 have a composition wherein z>0.15, such as 0.2<z<0.4. This may provide the most efficient doping enhancement.

Further, a charge carrier injecting layer of the device 1 may comprise a pillar layer 15. This may facilitate a high conductivity and/or mobility in the charge carrier injecting layer. Additionally, or alternatively, it may facilitate ballistic transport through the charge carrier injecting layer.

For example, the p-doped semiconductor layer 14 may comprise a pillar layer 15, the pillar layer 15 of the p-doped semiconductor layer 14 comprising at least one p-doped semiconductor pillar 16 embedded in supporting material 18.

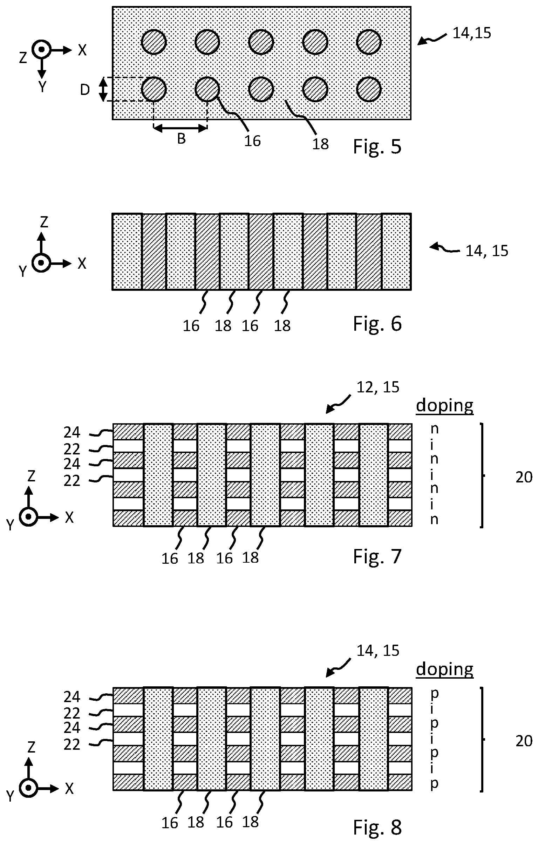

Figs. 5 and 6 illustrate a pillar layer 15. In the figures the pillar layer 15 forms a p-doped semiconductor layer 14. However, a pillar layer 15 may alternatively form a n-doped semiconductor layer 12, e.g. if the doping of the pillar layer 15 is reversed. Fig. 5 is a top view of the pillar layer 15, as viewed in the Z direction. Fig. 6 is a cross-sectional view of the pillar layer 15, as viewed in the Y direction.

The semiconductor pillars 16 of a pillar layer 15 may extend primarily along an axis, the axis being perpendicular to the substrate, i.e. in the Z direction.

The semiconductor pillars 16 may have a circular cross-section, as shown in Fig. 5. Alternatively, the semiconductor pillars 16 may have a non-circular cross-section. The semiconductor pillars 16 of a pillar layer 15 may have a diameter D in the range of 10 nm to 500 nm. If a semiconductor pillar 16 has a non-circular cross-section, the diameter D is the diameter of the smallest circle encompassing the non-circular cross-section.

The semiconductor pillars 16 of a pillar layer 15 may have a pitch B in the range of 200 nm to 500 nm. Herein, the pitch B is the distance between adjacent semiconductor pillars 16 in a periodic repetition of semiconductor pillars 16, as shown in Fig. 5.

A semiconductor pillar 16 of a pillar layer 15 may comprise one single semiconductor material e.g. Al(x)Ga(1-x)N wherein $0 \leq x \leq 1$. Alternatively, a semiconductor pillar 16 of a pillar layer 15 may comprise a superlattice 20 of GaN layers 22 and Al(z)Ga(1-z)N layers 24, wherein $0 < z \leq 1$. Fig. 7 illustrates a cross-sectional view of a pillar layer 15, as viewed in the Y direction, forming a n-doped semiconductor layer 12, wherein the semiconductor pillars 16 comprise a superlattice 20. Fig. 8 illustrates a cross-sectional view of a pillar layer 15, as viewed in the Y direction, forming a p-doped semiconductor layer 14, wherein the semiconductor pillars 16 comprise a superlattice 20.

A semiconductor pillar 16 of a pillar layer 15 is doped to form a transport channel for charge carriers. In the case where the pillar layer 15 forms part of a n-doped semiconductor layer 12, semiconductor pillars 16 of the pillar layer 15 are n-doped to form an electron transport channel through the pillar layer 15. In the case where the pillar layer 15 forms part of a p-doped semiconductor layer 14, semiconductor pillars 16 of the pillar layer 15 are p-doped to form a hole transport channel through the pillar layer 15. The doping may be constant along the axis of the semiconductor pillar 16. Alternatively, the doping may vary along the axis of the semiconductor pillar 16. In particular, in the case where the semiconductor pillar 16 comprises a superlattice 20, the GaN layers 22 may be intrinsically doped while the Al(z)Ga(1-z)N layers 24 are either p-doped, such that the semiconductor pillar 16 forms a hole transport channel, or n-doped, such that the semiconductor pillar 16 forms an electron transport channel.

A pillar layer 15 may be formed by growing a semiconductor layer, patterning said layer, and then etching out the semiconductor pillars 16. Space between the pillars may subsequently be filled by supporting material 18 such that the semiconductor pillars 16 are embedded, such as laterally embedded in the supporting material 18. The supporting material 18 may be epitaxially grown or deposited by other means.

The supporting material 18 may be a semiconductor material, e.g. an epitaxially grown semiconductor material. The supporting material 18 may be a semiconductor material with a doping opposite to the doping of the semiconductor pillars 16 embedded in said supporting material 18. Thus, for a n-doped semiconductor layer 12 a semiconductor pillar 16 of the pillar layer 15 may be n-doped and the supporting material 18 may be p-doped. Similarly, for a p-doped semiconductor layer 14 a semiconductor pillar 16 of the pillar layer 15 may be p-doped and the supporting material 18 may be n-doped.

Alternatively, or additionally, to using a doped semiconductor material for the supporting material 18, the supporting material 18 may be an oxide. For example, the supporting material may be a gallium oxide, e.g. $Ga_2O$ or $Ga_2O_3$.

A charge carrier concentration for light holes may be provided in the p-doped semiconductor layer by strain. Thus, at least part of the p-doped semiconductor layer 14 may be lattice mismatched to a surrounding, such that said part of the p-doped semiconductor layer 14 is strained. The term lattice mismatched herein refers to having a different lattice constant compared to the surrounding. The lattice mismatch may be configured to raise the light hole band energy above the heavy hole band energy for said part of the p-doped semiconductor layer 14.

In one example, the p-doped semiconductor layer 14 is lattice mismatched to an adjacent layer.

In another example, p-doped semiconductor pillars 16 of a pillar layer 15 of the p-doped semiconductor layer 14 are lattice mismatched to the supporting material 18 of the pillar layer 15.

As previously mentioned, the base layer 4 comprises Al(x)Ga(1-x)N wherein $0 < x \leq 1$. The base layer 4 may e.g. comprise one or more Al(x)Ga(1-x)N layers.

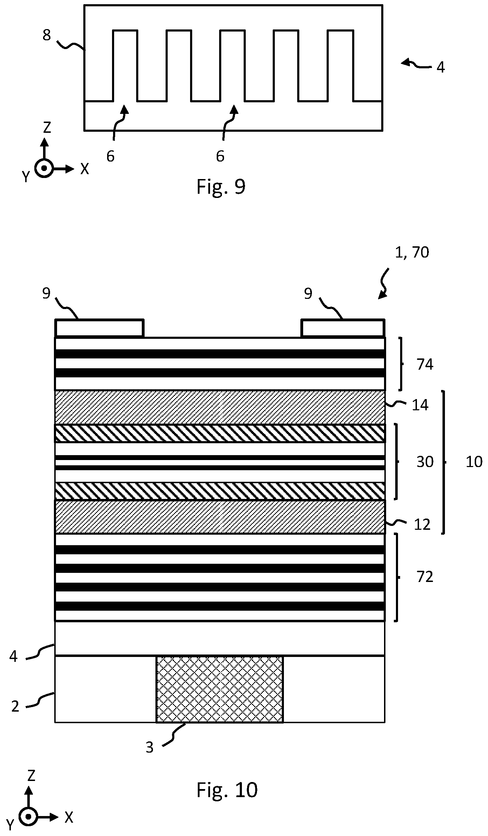

Additionally, or alternatively, the base layer 4 may comprise base layer pillars 6 laterally encased in base layer encasing material 8. Fig. 9 illustrates a cross-sectional view of such a base layer 4, seen in the Y direction.

A base layer pillar 6 is a pillar extending primarily along an axis, the axis being perpendicular to the substrate, i.e. in the Z direction.

A base layer pillar 6 may have a circular cross-section. Alternatively, a base layer pillar 6 may have a non-circular cross-section. The base layer pillar 6 may have a diameter smaller than 500 nm, such as smaller than 100 nm. If a base layer pillar 6 has a non-circular cross-section, the diameter is the diameter of the smallest circle encompassing the non-circular cross-section.

The base layer encasing material 8 encases the base layer pillar 6 laterally. Additionally, the base layer encasing material 8 may encase the top ends of the base layer pillars 6, as shown in Fig. 9.

The base layer pillars 6 may by AIN pillars and the base layer encasing material 8 may be $Al_xGa_{1-x}N$, wherein $0 \leq x \leq 0.95$.

The device 1 may be a laser, e.g. a vertical-cavity surface emitting laser (VCSEL) or an edge-emitting laser diode 70.

Fig. 10 illustrates a cross-sectional view of a device 1 in the form of a VCSEL 70. The illustrated VCSEL 70 comprises a bottom reflector 72 below the first 41 and second 42 quantum wells and a top reflector 74 above the first 41 and second 42 quantum wells, the top 74 and bottom 72 reflector forming an optical resonator for light emitted by the first 41 and second 42 quantum wells.

The bottom 72 and top 74 reflector may respectively be distributed Bragg reflectors (DBRs), as illustrated in Fig. 10. A DBR may comprise layers of alternating high and low refractive index. The thicknesses of the layers may be configured to correspond to a quarter of the emission wavelength, e.g. a quarter of the wavelength of the light emitted by the quantum wells 41, 42 of the quantum well layer structure 30. In Fig. 10 the bottom reflector 72 comprises four periods of alternating high and low refractive index and the top reflector 74 comprises two periods of alternating high and low refractive index.

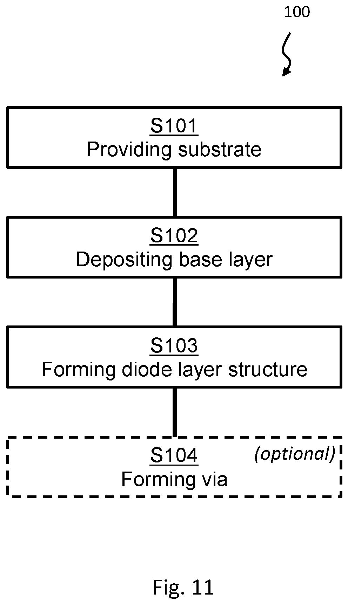

Fig. 11 shows a flow chart of a method 100 for producing a light-emitting device 1. The method 100 comprises providing S101 a substrate 2, depositing S102 a base layer 4, and forming S103 a diode layer structure 10.

The substrate 2 may be provided as e.g. a silicon substrate 2, a sapphire substrate 2, or a silicon carbide substrate 2.

The base layer 4, comprising Al(x)Ga(1-x)N, may be deposited S102 by physical vapor deposition, e.g. by sputtering.

The diode layer structure 10 may be formed S103 on the base layer 4 by sequentially forming a bottom charge carrier injecting layer, a first distal barrier layer 61, a first proximal barrier layer 51, a first quantum well 41, a barrier layer 43, a second quantum well 42, a second proximal barrier layer 52, a second distal barrier layer 62, and a top charge carrier injecting layer. Said layers of the diode layer structure 10 may be formed by epitaxial growth. The bottom charge carrier injecting layer may be a n-doped semiconductor layer 12 and the top charge carrier injecting layer a p-doped semiconductor layer 14, or vice versa.

Optionally, the method 100 may comprise forming S104 a via 3 by:

etching a hole through the substrate 2 by reactive ion etching; and

depositing metal in the hole through the substrate 2 such that a metal contact is formed, the metal contact going through the substrate and electrically connecting to the bottom charge carrier injecting layer.

The etching of the hole through the substrate 2 by reactive ion etching may be ended based on spectroscopically detecting molecular species of aluminum chloride or aluminum fluoride. The molecular species may e.g. be spectroscopically detected by UV-vis spectroscopy. The reactive ion etching of the hole through the substrate 2 may comprise creating a plasma which etches through the substrate 2. The plasma may emit light during the etching. Part of the light may originate from molecular species created by the etch gas reacting with the etched material. Thus, when the etching has passed through the substrate, e.g. through the silicon substrate 2, the etch gas may react with aluminum in the layers on the substrate. Thus, the etch gas may react with aluminum in e.g. the base layer 4 to form aluminum chloride or aluminum fluoride species which may emit light a characteristic spectrum when excited by the plasma.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A device (1) for emitting light, the device (1) comprising:

a substrate (2);
a base layer (4) arranged on the substrate (2), the base layer (4) comprising Al(x)Ga(1-x)N wherein $0 < x \leq 1$;
a diode layer structure (10) arranged on the base layer (4), the diode layer structure (10) comprising a quantum well layer structure (30)

sandwiched between an n-doped semiconductor layer (12) and a p-doped semiconductor layer (14);

the quantum well layer structure (30) comprising a first (41) and second (42) quantum well, a first (51) and a second (52) proximal barrier layer, and a first (61) and a second (62) distal barrier layer,

wherein the first (41) and second (42) quantum well each has a thickness below 5 nm and a bandgap smaller than bandgaps of the first (51) and second (52) proximal barrier layers;

wherein the first (51) and second (52) proximal barrier layer each comprises intrinsically doped GaN, wherein the first (41) and second (42) quantum wells are sandwiched between the first (51) and second (52) proximal barrier layers, wherein the first (61) and second (62) distal barrier layer each comprises $Al(a)Ga(1-a)N$ wherein $0 < a \leq 0.3$, wherein both the first (61) and the second (62) distal barrier layer have larger bandgaps than the first (51) and second (52) proximal barrier layers, wherein the first (41) and second (42) quantum wells and the first (51) and second (52) proximal barrier layers are sandwiched between the first (61) and second (62) distal barrier layers;

wherein the n-doped semiconductor layer (12) is configured to inject electrons into the quantum well layer structure (30);

wherein the p-doped semiconductor layer (14) is configured to inject holes into the quantum well layer structure (30), preferably wherein said base layer (4) is AIN having a thickness 100-500 nm.

2. The device (1) according to claim 1, wherein the quantum well layer structure (30) is configured to be substantially doped by a distal n-doped semiconductor layer and a distal p-doped semiconductor layer for recombination of electrons and holes.

3. The device (1) according to claim 1 or 2, wherein the quantum well layer structure (30) of the diode layer structure (10) comprises a plurality of quantum wells, wherein adjacent quantum wells of the plurality of quantum wells are separated by a barrier layer having a thickness less than 10 nm.

4. The device (1) according to any one of the preceding claims, wherein the p-doped semiconductor layer (14) comprises a superlattice (20) of GaN layers (22) and $Al(z)Ga(1-z)N$ layers (24), wherein $0 < z \leq 1$, wherein the $Al(z)Ga(1-z)N$ layers (24) of the superlattice (20) are p-doped.

5. The device (1) according to any one of the preceding claims, wherein the n-doped semiconductor layer (12) comprises a superlattice (20) of GaN layers (22) and $Al(z)Ga(1-z)N$ layers (24), wherein $0 < z \leq 1$, wherein the $Al(z)Ga(1-z)N$ layers (24) of the superlattice (20) are n-doped.

6. The device (1) according to any one of the preceding claims, further comprising a via (3), the via (3) being a metal contact going through the substrate (2) and electrically connecting to the n-doped semiconductor layer (12) or to the p-doped semiconductor layer (14) of the diode layer structure (10).

7. The device (1) according to any one of the preceding claims, wherein

the n-doped semiconductor layer (12) comprises a pillar layer (15), the pillar layer (15) of the n-doped semiconductor layer (12) comprising at least one n-doped semiconductor pillar (16) embedded in supporting material (18), wherein the at least one n-doped semiconductor pillar (16) is configured to form an electron transport channel through the pillar layer (15) of the n-doped semiconductor layer (12) to the quantum well layer structure (30); and/or

the p-doped semiconductor layer (14) comprises a pillar layer (15), the pillar layer (15) of the p-doped semiconductor layer (14) comprising at least one p-doped semiconductor pillar (16) embedded in supporting material (18), wherein the at least one p-doped semiconductor pillar (16) is configured to form a hole transport channel through the pillar layer (15) of the p-doped semiconductor layer (14) to the quantum well layer structure (30).

8. The device (1) according to claim 7, wherein, for one or more pillar layers (15) of the device (1), the supporting material (18) is a semiconductor material with a doping opposite to the doping of the semiconductor pillars (16) embedded in said supporting material (18).

9. The device (1) according to claim 7 or 8, wherein, for one or more pillar layers (15) of the device (1), the supporting material (18) is a gallium oxide.

10. The device (1) according to any one of claims 7-9, wherein, for one or more pillar layers (15) of the device (1), a diameter (D) of the semiconductor pillars (16) is 10-500 nm and a pitch (B) of the semiconductor pillars (16) is 200-500 nm.

11. The device (1) according to any one of the preceding claims, wherein a charge carrier concentration for light holes is provided in the p-doped semiconductor layer (14) by strain.

12. The device (1) according to any one of the preceding claims, wherein the device (1) is a vertical-cavity surface emitting laser (70) comprising a bottom reflector (72) below the first (41) and second (42) quantum wells and a top reflector (74) above the first (41) and second (42) quantum wells, the top (74) and bottom (72) reflector forming an optical resonator for light emitted by the first (41) and second (42) quantum wells.

13. A method (100) for producing a light-emitting device (1), the method comprising:

    providing (S101) a substrate (2);
    depositing (S102), by physical vapor deposition, a base layer (4) on the substrate (2), the base layer (4) comprising Al(x)Ga(1-x)N;
    forming (S103) a diode layer structure (10) on the base layer (4), the diode layer structure (10) comprising a quantum well layer structure (30) sandwiched between an n-doped semiconductor layer (12) and a p-doped semiconductor layer (14),
    the quantum well layer structure (30) comprising a first (41) and second (42) quantum well, a first (51) and a second (52) proximal barrier layer, and a first (61) and a second (62) distal barrier layer,
    wherein the first (41) and second (42) quantum well each has a thickness below 5 nm and a bandgap smaller than bandgaps of the first (51) and second (52) proximal barrier layers;
    wherein the first (51) and second (52) proximal barrier layer each comprises intrinsically doped GaN, wherein the first (41) and second (42) quantum wells are sandwiched between the first (51) and second (52) proximal barrier layers,
    wherein the first (61) and second (62) distal barrier layer each comprises Al(a)Ga(1-a)N wherein 0 < a ≤ 0.3, wherein both the first (61) and the second (62) distal barrier layer have larger bandgaps than the first (51) and second (52) proximal barrier layers, wherein the first (41) and second (42) quantum wells and the first (51) and second (52) proximal barrier layers are sandwiched between the first (61) and second (62) distal barrier layers;
    wherein the n-doped semiconductor layer (12) is configured to inject electrons into the quantum well layer structure (30);
    wherein the p-doped semiconductor layer (14) is configured to inject holes into the quantum well layer structure (30), preferably wherein said base layer (4) is AlN having a thickness 100-500 nm.

14. The method according to claim 13, further comprising:

etching a hole through the substrate (2) by reactive ion etching; and
depositing metal in the hole through the substrate (2) such that a metal contact is formed, the metal contact going through the substrate (2) and electrically connecting to the n-doped semiconductor layer (12) or to the p-doped semiconductor layer (14) of the diode layer structure (10).

15. The method according to claim 14, wherein the etching of the hole through the substrate (2) by reactive ion etching is ended based on spectroscopically detecting molecular species of aluminum chloride or aluminum fluoride.

**Patentansprüche**

1. Vorrichtung (1) zum Emittieren von Licht, wobei die Vorrichtung (1) umfasst:

    ein Substrat (2);
    eine Grundschicht (4), die auf dem Substrat (2) angeordnet ist, wobei die Grundschicht (4) Al(x)Ga(1-x)N umfasst, wobei 0 < x ≤ 1;
    eine Diodenschichtstruktur (10), die auf der Grundschicht (4) angeordnet ist, wobei die Diodenschichtstruktur (10) eine Quantentopfschichtstruktur (30) umfasst, die sandwichartig zwischen einer n-dotierten Halbleiterschicht (12) und einer p-dotierten Halbleiterschicht (14) angeordnet ist;
    wobei die Quantentopfschichtstruktur (30) einen ersten Quantentopf (41) und einen zweiten Quantentopf (42), eine erste proximale Barriereschicht (51) und eine zweite proximale Barriereschicht (52) und eine erste distale Barriereschicht (61) und eine zweite distale Barriereschicht (62) umfasst,
    wobei der erste Quantentopf (41) und der zweite Quantentopf (42) jeweils eine Dicke von weniger als 5 nm und eine Bandlücke aufweisen, die kleiner als Bandlücken der ersten proximalen Barriereschicht (51) und der zweiten proximalen Barriereschicht (52) ist;
    wobei die erste proximale Barriereschicht (51) und die zweite proximale Barriereschicht (52) jeweils intrinsisch dotiertes GaN umfassen, wobei der erste Quantentopf (41) und der zweite Quantentopf (42) sandwichartig zwischen der ersten proximalen Barriereschicht (51) und der zweiten proximalen Barriereschicht (52) angeordnet sind,
    wobei die erste distale Barriereschicht (61) und die zweite distale Barriereschicht (62) jeweils Al(a)Ga(1-a)N umfassen, wobei 0 < a ≤ 0,3, wobei sowohl die erste distale Barriereschicht (61) als auch die zweite distale Barriereschicht (62) größere Bandlücken als die erste proximale Barriereschicht (51) und die zweite proximale Barriereschicht (52) aufweisen, wobei der erste Quantentopf (41) und der zweite Quantentopf (42) und die erste proximale Barriereschicht (51) und die zweite proximale Barriereschicht (52) sandwichartig zwischen der ersten distalen Barriereschicht (61) und der zweiten distalen Barriereschicht (62) angeordnet sind;
wobei die n-dotierte Halbleiterschicht (12) dazu ausgestaltet ist, Elektronen in die Quantentopfschichtstruktur (30) zu injizieren;
wobei die p-dotierte Halbleiterschicht (14) dazu ausgestaltet ist, Löcher in die Quantentopfschichtstruktur (30) zu injizieren, vorzugsweise wobei die Grundschicht (4) AlN mit einer Dicke von 100 bis 500 nm ist.

2. Vorrichtung (1) nach Anspruch 1, wobei die Quantentopfschichtstruktur (30) dazu ausgestaltet ist, durch eine distale n-dotierte Halbleiterschicht und eine distale p-dotierte Halbleiterschicht zur Rekombination von Elektronen und Löchern im Wesentlichen dotiert zu werden.

3. Vorrichtung (1) nach Anspruch 1 oder 2, wobei die Quantentopfschichtstruktur (30) der Diodenschichtstruktur (10) eine Mehrzahl von Quantentöpfen umfasst, wobei angrenzende Quantentöpfe der Mehrzahl von Quantentöpfen durch eine Barriereschicht mit einer Dicke von weniger als 10 nm getrennt sind.

4. Vorrichtung (1) nach einem der vorhergehenden Ansprüche, wobei die p-dotierte Halbleiterschicht (14) ein Übergitter (20) ein Übergitter (20) aus GaN-Schichten (22) und Al(z)Ga(1-z)N-Schichten (24) ist, wobei 0 < z ≤ 1, wobei die Al(z)Ga(1-z)N-Schichten (24) des Übergitters (20) p-dotiert sind.

5. Vorrichtung (1) nach einem der vorhergehenden Ansprüche, wobei die n-dotierte Halbleiterschicht (12) ein Übergitter (20) aus GaN-Schichten (22) und Al(z)Ga(1-z)N-Schichten (24) ist, wobei 0 < z ≤ 1, wobei die Al(z)Ga(1-z)N-Schichten (24) des Übergitters (20) n-dotiert sind.

6. Vorrichtung (1) nach einem der vorhergehenden Ansprüche, ferner umfassend eine Durchkontaktierung (3), wobei die Durchkontaktierung (3) ein Metallkontakt ist, der durch das Substrat (2) verläuft und eine elektrische Verbindung mit der n-dotierten Halbleiterschicht (12) oder der p-dotierten Halbleiterschicht (14) der Diodenschichtstruktur (10) bildet.

7. Vorrichtung (1) nach einem der vorhergehenden Ansprüche, wobei

die n-dotierte Halbleiterschicht (12) eine Säulenschicht (15) umfasst, wobei die Säulenschicht (15) der n-dotierten Halbleiterschicht (12) mindestens eine n-dotierte Halbleitersäule (16) umfasst, die in Stützmaterial (18) eingebettet ist, wobei die mindestens eine n-dotierte Halbleitersäule (16) dazu konfiguriert ist, einen Elektronentransportkanal durch die Säulenschicht (15) der n-dotierten Halbleiterschicht (12) zu der Quantentopfschichtstruktur (30) zu bilden; und/oder
die p-dotierte Halbleiterschicht (14) eine Säulenschicht (15) umfasst, wobei die Säulenschicht (15) der p-dotierten Halbleiterschicht (14) mindestens eine p-dotierte Halbleitersäule (16) umfasst, die in Stützmaterial (18) eingebettet ist, wobei die mindestens eine p-dotierte Halbleitersäule (16) dazu konfiguriert ist, einen Lochtransportkanal durch die Säulenschicht (15) der n-dotierten Halbleiterschicht (14) zu der Quantentopfschichtstruktur (30) zu bilden.

8. Vorrichtung (1) nach Anspruch 7, wobei das Stützmaterial (18) in Bezug auf eine oder mehrere Säulenschichten (15) der Vorrichtung (1) ein Halbleitermaterial mit einer Dotierung ist, die der Dotierung der Halbleitersäulen (16), die in dem Stützmaterial (18) eingebettet sind, entgegengesetzt ist.

9. Vorrichtung (1) nach Anspruch 7 oder 8, wobei das Stützmaterial (18) in Bezug auf eine oder mehrere Säulenschichten (15) der Vorrichtung (1) ein Galliumoxid ist.

10. Vorrichtung (1) nach einem der Ansprüche 7 bis 9, wobei ein Durchmesser (D) der Halbleitersäulen (16) in Bezug auf eine oder mehrere Säulenschichten (15) der Vorrichtung (1) 10 bis 500 nm beträgt und ein Pitch (B) der Halbleitersäulen (16) 200 bis 500 nm beträgt.

11. Vorrichtung (1) nach einem der vorhergehenden Ansprüche, wobei eine Ladungsträgerkonzentration für Lichtlöcher durch Spannung in der p-dotierten Halbleiterschicht (14) bereitgestellt wird.

12. Vorrichtung (1) nach einem der vorhergehenden Ansprüche, wobei die Vorrichtung (1) ein oberflächenemittierender Laser (70) mit vertikalem Resonator ist, der einen unteren Reflektor (72) unter dem ersten Quantentopf (41) und dem zweiten Quantentopf (42) und einen oberen Reflektor (74) über dem ersten Quantentopf (41) und dem zweiten Quantentopf (42) umfasst, wobei der obere Reflektor (74) und der untere Reflektor (72) einen optischen Resonator für Licht bilden, das von dem ersten Quantentopf (41) und dem zweiten Quantentopf (42) emittiert wird.

**13.** Verfahren (100) zum Herstellen einer lichtemittierenden Vorrichtung (1), wobei das Verfahren umfasst:

Bereitstellen (S101) eines Substrats (2);
Abscheiden (S102) einer Grundschicht (4) durch physikalische Dampfphasenabscheidung auf dem Substrat (2), wobei die Grundschicht (4) Al(x)Ga(1-x)N umfasst;
Bilden (S103) einer Diodenschichtstruktur (10) auf der Grundschicht (4), wobei die Diodenschichtstruktur (10) eine Quantentopfschichtstruktur (30) umfasst, die sandwichartig zwischen einer n-dotierten Halbleiterschicht (12) und einer p-dotierten Halbleiterschicht (14) angeordnet ist,
wobei die Quantentopfschichtstruktur (30) einen ersten Quantentopf (41) und einen zweiten Quantentopf (42), eine erste proximale Barriereschicht (51) und eine zweite proximale Barriereschicht (52) und eine erste distale Barriereschicht (61) und eine zweite distale Barriereschicht (62) umfasst,
wobei der erste Quantentopf (41) und der zweite Quantentopf (42) jeweils eine Dicke von weniger als 5 nm und eine Bandlücke aufweisen, die kleiner als Bandlücken der ersten proximalen Barriereschicht (51) und der zweiten proximalen Barriereschicht (52) ist;
wobei die erste proximale Barriereschicht (51) und die zweite proximale Barriereschicht (52) jeweils intrinsisch dotiertes GaN umfassen, wobei der erste Quantentopf (41) und der zweite Quantentopf (42) sandwichartig zwischen der ersten proximalen Barriereschicht (51) und der zweiten proximalen Barriereschicht (52) angeordnet sind,
wobei die erste distale Barriereschicht (61) und die zweite distale Barriereschicht (62) jeweils Al(a)Ga(1-a)N umfassen, wobei $0 < a \leq 0,3$, wobei sowohl die erste distale Barriereschicht (61) als auch die zweite distale Barriereschicht (62) größere Bandlücken als die erste proximale Barriereschicht (51) und die zweite proximale Barriereschicht (52) aufweist, wobei der erste Quantentopf (41) und der zweite Quantentopf (42) und die erste proximale Barriereschicht (51) und die zweite proximale Barriereschicht (52) sandwichartig zwischen der ersten distalen Barriereschicht (61) und der zweiten distalen Barriereschicht (62) angeordnet sind;
wobei die n-dotierte Halbleiterschicht (12) dazu ausgestaltet ist, Elektronen in die Quantentopfschichtstruktur (30) zu injizieren;
wobei die p-dotierte Halbleiterschicht (14) dazu ausgestaltet ist, Löcher in die Quantentopfschichtstruktur (30) zu injizieren, vorzugsweise wobei die Grundschicht (4) AlN mit einer Dicke von 100 bis 500 nm ist.

**14.** Verfahren nach Anspruch 13, ferner umfassend:

Ätzen eines Lochs durch das Substrat (2) durch reaktives Ionenätzen; und
Abscheiden von Metall in dem Loch durch das Substrat (2), so dass ein Metallkontakt gebildet wird, wobei der Metallkontakt durch das Substrat (2) verläuft und eine elektrische Verbindung mit der n-dotierten Halbleiterschicht (12) oder der p-dotierten Halbleiterschicht (14) der Diodenschichtstruktur (10) bildet.

**15.** Verfahren nach Anspruch 14, wobei das Ätzen des Lochs durch das Substrat (2) durch reaktives Ionenätzen auf der Grundlage dessen beendet wird, dass spektroskopisch molekulare Spezies von Aluminiumchlorid oder Aluminiumfluorid nachgewiesen werden.

**Revendications**

**1.** Dispositif (1) pour émettre de la lumière, le dispositif (1) comprenant :

un substrat (2) ;
une couche de base (4) agencée sur le substrat (2), la couche de base (4) comprenant Al(x)Ga(1-x)N où $0 < x \leq 1$;
une structure de couches de diode (10) agencée sur la couche de base (4), la structure de couches de diode (10) comprenant une structure de puits quantiques (30) prise en sandwich entre une couche semi-conductrice dopée n (12) et une couche semi-conductrice dopée p (14) ;
la structure de puits quantiques (30) comprenant un premier (41) et un second (42) puits quantique, une première (51) et une seconde (52) couche barrière proximale, et une première (61) et une seconde (62) couche barrière distale,
dans lequel le premier (41) et le second (42) puits quantique ont chacun une épaisseur inférieure à 5 nm et une bande interdite plus petite que les bandes interdites de la première (51) et de la seconde (52) couche barrière proximale ;
dans lequel la première (51) et la seconde (52) couche barrière proximale comprennent chacune GaN dopé intrinsèquement, dans lequel le premier (41) et le second (42) puits quantique sont pris en sandwich entre la première (51) et la seconde (52) couche barrière proximale,
dans lequel la première (61) et la seconde (62) couche barrière distale comprennent chacune Al(a)Ga(1-a)N où $0 < a \leq 0.3$, dans lequel la première (61) et la seconde (62) couche barrière distale ont toutes deux des bandes interdites plus grandes que la première (51) et la seconde (52) couche barrière proximale, dans lequel le premier (41) et le second (42) puits quantique ainsi que la première (51) et la seconde (52) couche barrière proximale sont pris en sandwich entre la première (61) et la seconde (62) couche barrière distale ;

dans lequel la couche semi-conductrice dopée n (12) est configurée pour injecter des électrons dans la structure de puits quantiques (30) ;

dans lequel la couche semi-conductrice dopée p (14) est configurée pour injecter des trous dans la structure de puits quantiques (30), de préférence dans lequel ladite couche de base (4) est AlN ayant une épaisseur de 100 à 500 nm.

2. Dispositif (1) selon la revendication 1, dans lequel la structure de puits quantiques (30) est configurée pour être substantiellement dopée par une couche semi-conductrice dopée n distale et une couche semi-conductrice dopée p distale pour la recombinaison d'électrons et de trous.

3. Dispositif (1) selon la revendication 1 ou 2, dans lequel la structure de puits quantiques (30) de la structure de couches de diode (10) comprend une pluralité de puits quantiques, dans lequel des puits quantiques adjacents de la pluralité de puits quantiques sont séparés par une couche barrière ayant une épaisseur inférieure à 10 nm.

4. Dispositif (1) selon l'une quelconque des revendications précédentes, dans lequel la couche semi-conductrice dopée p (14) comprend un super-réseau (20) de couches de GaN (22) et de couches Al(z)Ga(1-z)N (24), où $0 < z \leq 1$, dans lequel les couches de Al(z)Ga(1- z)N (24) du super-réseau (20) sont dopées p.

5. Dispositif (1) selon l'une quelconque des revendications précédentes, dans lequel la couche semi-conductrice dopée n (12) comprend un super-réseau (20) de couches de GaN (22) et de couches Al(z)Ga(1-z)N (24), où $0 < z \leq 1$, dans lequel les couches de Al(z)Ga(1- z)N (24) du super-réseau (20) sont dopées n.

6. Dispositif (1) selon l'une quelconque des revendications précédentes, comprenant en outre un via (3), le via (3) étant un contact métallique traversant le substrat (2) et se connectant électriquement à la couche semi-conductrice dopée n (12) ou à la couche semi-conductrice dopée p (14) de la structure de couches de diode (10).

7. Dispositif (1) selon l'une quelconque des revendications précédentes, dans lequel

la couche semi-conductrice dopée n (12) comprend une couche de piliers (15), la couche de piliers (15) de la couche semi-conductrice dopée n (12) comprenant au moins un pilier semi-conducteur dopé n (16) noyé dans un matériau de support (18), dans lequel l'au moins un pilier semi-conducteur dopé n (16) est configuré pour former un canal de transport d'électrons à travers la couche de piliers (15) de la couche semi-conductrice dopée n (12) jusqu'à la structure de puits quantiques (30) ; et/ou

la couche semi-conductrice dopée p (14) comprend une couche de piliers (15), la couche de piliers (15) de la couche semi-conductrice dopée p (14) comprenant au moins un pilier semi-conducteur dopé p (16) noyé dans un matériau de support (18), dans lequel l'au moins un pilier semi-conducteur dopé p (16) est configuré pour former un canal de transport de trous à travers la couche de piliers (15) de la couche semi-conductrice dopée p (14) jusqu'à la structure de puits quantiques (30).

8. Dispositif (1) selon la revendication 7, dans lequel, pour une ou plusieurs couches de piliers (15) du dispositif (1), le matériau de support (18) est un matériau semi-conducteur avec un dopage opposé au dopage des piliers semi-conducteurs (16) noyés dans ledit matériau de support (18).

9. Dispositif (1) selon la revendication 7 ou 8, dans lequel, pour une ou plusieurs couches de piliers (15) du dispositif (1), le matériau de support (18) est un oxyde de gallium.

10. Dispositif (1) selon l'une quelconque des revendications 7 à 9, dans lequel, pour une ou plusieurs couches de piliers (15) du dispositif (1), un diamètre (D) des piliers semi-conducteurs (16) est de 10 à 500 nm et un pas (B) des piliers semi-conducteurs (16) est de 200 à 500 nm.

11. Dispositif (1) selon l'une quelconque des revendications précédentes, dans lequel une concentration de porteurs de charge pour les trous légers est fournie dans la couche semi-conductrice dopée p (14) par contrainte.

12. Dispositif (1) selon l'une quelconque des revendications précédentes, dans lequel le dispositif (1) est un laser à cavité verticale émettant par la surface (70) comprenant un réflecteur inférieur (72) sous les premier (41) et second (42) puits quantiques et un réflecteur supérieur (74) au-dessus des premier (41) et second (42) puits quantiques, le réflecteur supérieur (74) et le réflecteur inférieur (72) formant un résonateur optique pour la lumière émise par les premier (41) et second (42) puits quantiques.

13. Procédé (100) pour produire un dispositif émetteur de lumière (1), le procédé comprenant :

la fourniture (S101) d'un substrat (2) ;

le dépôt (S102), par dépôt physique en phase vapeur, d'une couche de base (4) sur le substrat (2), la couche de base (4) comprenant Al(x)Ga(1-x)N ;

la formation (S103) d'une structure de couches de diode (10) sur la couche de base (4), la structure de couches de diode (10) comprenant une structure de couches de puits quantiques (30) prise en sandwich entre une couche semi-conductrice dopée n (12) et une couche semi-conductrice dopée p (14),

la structure de couches de puits quantiques (30) comprenant un premier (41) et un second (42) puits quantique, une première (51) et une seconde (52) couche barrière proximale, et une première (61) et une seconde (62) couche barrière distale,

dans lequel le premier (41) et le second (42) puits quantique ont chacun une épaisseur inférieure à 5 nm et une bande interdite plus petite que les bandes interdites de la première (51) et de la seconde (52) couche barrière proximale ;

dans lequel la première (51) et la seconde (52) couche barrière proximale comprennent chacune GaN dopé intrinsèquement, dans lequel le premier (41) et le second (42) puits quantique sont pris en sandwich entre la première (51) et la seconde (52) couche barrière proximale,

dans lequel la première (61) et la seconde (62) couche barrière distale comprennent chacune Al(a)Ga(1-a)N où $0 < a \leq 0.3$, dans lequel la première (61) et la seconde (62) couche barrière distale ont toutes deux des bandes interdites plus grandes que la première (51) et la seconde (52) couche barrière proximale, dans lequel le premier (41) et le second (42) puits quantique ainsi que la première (51) et la seconde (52) couche barrière proximale sont pris en sandwich entre la première (61) et la seconde (62) couche barrière distale ;

dans lequel la couche semi-conductrice dopée n (12) est configurée pour injecter des électrons dans la structure de couches de puits quantiques (30) ;

dans lequel la couche semi-conductrice dopée p (14) est configurée pour injecter des trous dans la structure de couches de puits quantiques (30), de préférence dans lequel ladite couche de base (4) est AlN ayant une épaisseur de 100 à 500 nm.

14. Procédé selon la revendication 13, comprenant en outre :

la gravure d'un trou à travers le substrat (2) par gravure ionique réactive ; et

le dépôt de métal dans le trou à travers le substrat (2) de telle sorte qu'un contact métallique soit formé, le contact métallique traversant le substrat (2) et se connectant électriquement à la couche semi-conductrice dopée n (12) ou à la couche semi-conductrice dopée p (14) de la structure de couches de diode (10).

15. Procédé selon la revendication 14, dans lequel la gravure du trou à travers le substrat (2) par gravure ionique réactive est interrompue sur la base d'une détection spectroscopique d'espèces moléculaires de chlorure d'aluminium ou de fluorure d'aluminium.

Fig. 1

Conduction band

Valence band

12  61  51  41  43  42  52  62  14

Z →

Fig. 2

14
40
40
40
40
12

30

Z
Y ⊙ → X

Fig. 3

14

doping

24  p
22  i
24  p
22  i
24  p
22  i
24  p

20

Z
Y ⊙ → X

Fig. 4

Fig. 5

Fig. 6

doping

Fig. 7

doping

Fig. 8

Fig. 9

Fig. 10

100

```
┌─────────────────────────────────┐
│            S101                 │
│      Providing substrate        │
└─────────────────────────────────┘
                │
┌─────────────────────────────────┐
│            S102                 │
│      Depositing base layer      │
└─────────────────────────────────┘
                │
┌─────────────────────────────────┐
│            S103                 │
│   Forming diode layer structure │
└─────────────────────────────────┘
                │
┌ ─ ─ ─ ─ ─ ─ ─ ─ ─ ─ ─ ─ ─ ─ ─ ─ ┐
│     S104         (optional)     │
│     Forming via                 │
└ ─ ─ ─ ─ ─ ─ ─ ─ ─ ─ ─ ─ ─ ─ ─ ─ ┘
```

Fig. 11

**EP 4 480 013 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1959530 A1

**Non-patent literature cited in the description**

- **KOZODOY et al.** *Appl. Phys. Lett.*, 1999, vol. 75, 2444

- **KOZODOY et al.** *Appl. Phys. Lett.*, 1999, vol. 75, 2444-2446